# EUROPEAN PATENT APPLICATION

(11) **EP 4 760 293 A1**
(43) Date of publication of application: **17.06.2026**
(21) Application number: 25204310.4
(22) Date of filing: 24.09.2025
(51) Int. Cl.: G01R 31/367, G01R 31/387, G01R 31/392

(54) **APPARATUS AND METHOD FOR ANALYZING BATTERY CHARACTERISTIC**

(30) Priority: 12.12.2024 KR 20240184493
(71) Applicant: SAMSUNG SDI CO., LTD., Yongin-si, Gyeonggi-do 17084 (KR)
(72) Inventor: RYU, Ji Hyun, 16678 Suwon-si (KR); KWON, Moon Seok, 16678 Suwon-si (KR); KA, Bok Hyun, 16678 Suwon-si (KR)
(74) Representative: Marks & Clerk LLP

(57) **Abstract**

The present disclosure relates to an apparatus and method for analyzing a battery characteristic. The technical object to be solved is to provide a solution capable of identifying a characteristic change of a battery cell that occurs during a plurality of charge/discharge cycles of a battery and detecting lithium precipitation that may occur during high-speed charging of the battery. To this end, the present disclosure provides a configuration for aligning a plurality of individual characteristic data acquired during a plurality of charge/discharge cycles of a battery based on capacity coordinates to generate integrated characteristic data and analyzing a charge characteristic or a discharge characteristic of the battery based on the generated integrated characteristic data.

## Description

### FIELD

The present disclosure relates to an apparatus and method for analyzing a battery characteristic.

### BACKGROUND

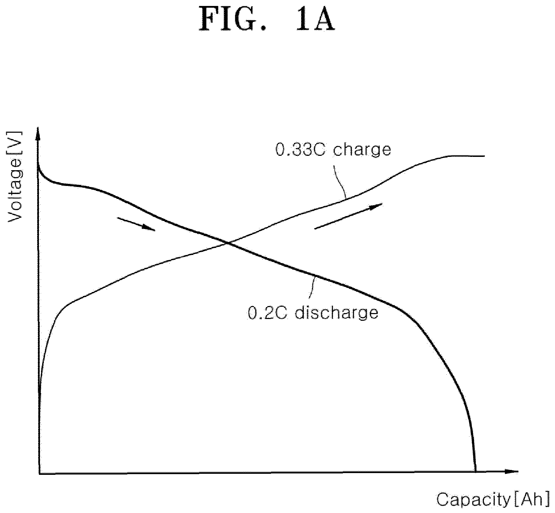

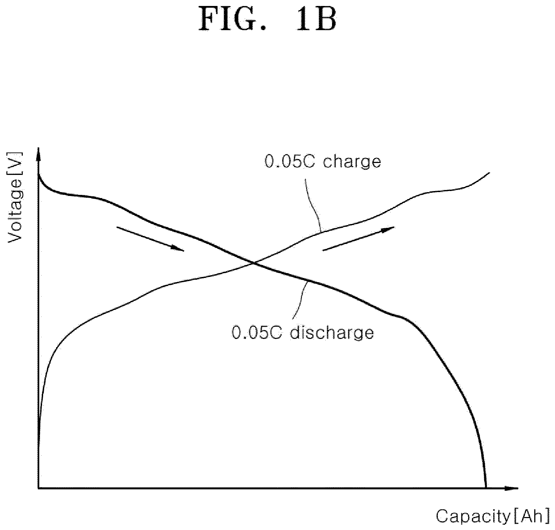

FIGS. 1A and 1B show examples of a typical charge curve and discharge curve of a battery cell according to a comparative device which does not implement aspects of the present disclosure. An X-axis of the charge and discharge curves is set to capacity (Ah), and a Y-axis thereof is set to voltage (V). Through such charge curves and discharge curves, only a voltage change according to a capacity change, only charge capacity, and only discharge capacity may be identified during charging and discharging processes of a battery. A characteristic change of a battery cell, which occurs during a plurality of charge/discharge cycles, cannot be identified through conventional charge curves and discharge curves.

The above information disclosed in this Background section is for enhancement of understanding of the background of the present disclosure, and therefore, it may contain information that does not constitute related (or prior) art.

### SUMMARY

The present disclosure is directed to providing an apparatus and method for analyzing a battery characteristic, which are capable of identifying a characteristic change of a battery cell that occur during a plurality of charge/discharge cycles of a battery and detecting lithium precipitation that may occur while performing high-speed charging of the battery.

However, objects that the present disclosure intends to achieve are not limited to the herein-described objects and other objects that are not described may be clearly understood by those skilled in the art from the following description.

According to aspects of the present disclosure, there is provided an apparatus for analyzing a battery characteristic, which includes a memory configured to store first individual characteristic data and second individual characteristic data respectively acquired in a first charge/discharge cycle and a second charge/discharge cycle, each of which consists of a charge operation and a discharge operation of a battery, wherein the first individual characteristic data includes first charge characteristic data and first discharge characteristic data which have a capacity coordinate as a reference axis, and the second individual characteristic data includes second charge characteristic data and second discharge characteristic data which have a capacity coordinate as a reference axis, and a processor configured to align the first discharge characteristic data with the second charge characteristic data to generate integrated characteristic data in which the first individual characteristic data and the second individual characteristic data are integrated and analyze a charge characteristic or discharge characteristic of the battery based on the generated integrated characteristic data.

The first charge characteristic data and the second charge characteristic data may have a form in which the capacity coordinate is inverted.

The processor may align the first discharge characteristic data with the second charge characteristic data based on reference capacity coordinate values defined according to the first discharge characteristic data.

The reference capacity coordinate values may be capacity coordinate values corresponding to a discharge end point of the first discharge characteristic data.

The processor may align the first discharge characteristic data with the second charge characteristic data based on the reference capacity coordinate values by shifting the second charge characteristic data by a capacity difference between charge capacity of the second charge characteristic data and discharge capacity of the first discharge characteristic data.

The processor may shift the second discharge characteristic data by the capacity difference to align the second charge characteristic data with the second discharge characteristic data based on capacity coordinate values corresponding to a charge end point of the second charge characteristic data.

The processor may analyze a lithium precipitation characteristic while charging the battery based on the integrated characteristic data.

The processor may analyze the lithium precipitation characteristic based on a difference between first capacity coordinate values corresponding to a charge end point of the first charge characteristic data and second capacity coordinate values corresponding to a charge end point of the second charge characteristic data in the integrated characteristic data.

The processor may determine that a lithium precipitation amount is increased while charging the battery as the difference between the first capacity coordinate values and the second capacity coordinate values is increased.

A C-rate applied to the second charge/discharge cycle may have a greater value than a C-rate applied to the first charge/discharge cycle.

Based on the integrated characteristic data, the processor may analyze degradation of charge capacity using the charge characteristic of the battery or may analyze degradation of discharge capacity of the battery using the discharge characteristic of the battery.

According to aspects of the present disclosure, there is provided an apparatus for analyzing a battery characteristic, which includes a processor, and a memory configured to store instructions executed by the processor, wherein the processor acquires first individual characteristic data including first charge characteristic data and first discharge characteristic data of a battery through a charge operation and a discharge operation of the battery in a first charge/discharge cycle, acquires second individual characteristic data including second charge characteristic data and second discharge characteristic data of the battery through a charge operation and a discharge operation of the battery in a second charge/discharge cycle, aligns the first discharge characteristic data with the second charge characteristic data to generate integrated characteristic data in which the first individual characteristic data and the second individual characteristic data are integrated, and analyzes a charge characteristic or a discharge characteristic of the battery based on the generated integrated characteristic data.

According to aspects of the present disclosure, there is provided a method of analyzing a battery characteristic, which includes acquiring, by a processor, first individual characteristic data including first charge characteristic data and first discharge characteristic data of a battery through a charge operation and a discharge operation of the battery in a first charge/discharge cycle, acquiring, by the processor, second individual characteristic data including second charge characteristic data and second discharge characteristic data of the battery through a charge operation and a discharge operation of the battery in a second charge/discharge cycle, aligning, by the processor, the first discharge characteristic data with the second charge characteristic data to generate integrated characteristic data in which the first individual characteristic data and the second individual characteristic data are integrated, and analyzing, by the processor, a charge characteristic or a discharge characteristic of the battery based on the generated integrated characteristic data.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIGS. 1A and 1B are example graphs showing comparative charge and discharge curves;
FIG. 2 is a block diagram illustrating an apparatus for analyzing a battery characteristic according to embodiments of the present disclosure;
FIGS. 3 to 6 are example graphs showing a process of generating integrated characteristic data according to embodiments of the present disclosure;
FIG. 7 is an example graph of integrated characteristic data according to embodiments of the present disclosure;
FIGS. 8 and 9 are example graphs for describing a method of analyzing a lithium precipitation characteristic according to embodiments of the present disclosure; and
FIG. 10 is a flowchart illustrating a method of analyzing a battery characteristic according to embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

As described herein, through conventional charge curves and discharge curves, only a voltage change according to a capacity change, only charge capacity, and only discharge capacity may be identified during charging and discharging processes of a battery. There is a limitation in that a characteristic change of a battery cell, which occurs during a plurality of charge/discharge cycles, cannot be identified through conventional charge curves and discharge curves.

In addition, the high-energy density and long lifespan characteristics of a battery are important indicators that indicate the performance of the battery. In order to improve the performance of a battery, the characteristics of the battery that are exhibited during high-speed charging (which has the same meaning as quick charging or high-rate charging), for example, lithium deposition characteristics, are essential battery specifications that should be strengthened. In general, as compared to low-speed charging (which has the same meaning as slow charging or low-rate charging) of a battery, in the case of high-speed charging, there is a large amount of lithium precipitation amount, which becomes a factor causing degradation of the lifespan characteristics of the battery. However, there is a limitation in that a lithium precipitation amount formed during high-speed charging cannot also be identified through conventional charge curves and discharge curves.

Hereinafter, a configuration of the present embodiment, which is adopted to identify a time sequential characteristic change of a battery cell that occurs during a plurality of charge/discharge cycles and at the same time accurately detect lithium precipitation that may occur during high-speed charging of a battery, will be described in detail.

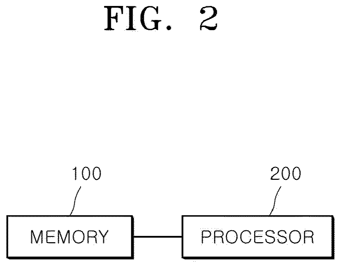

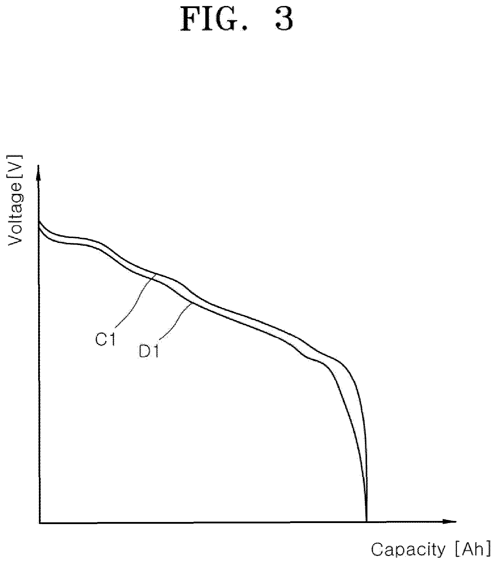

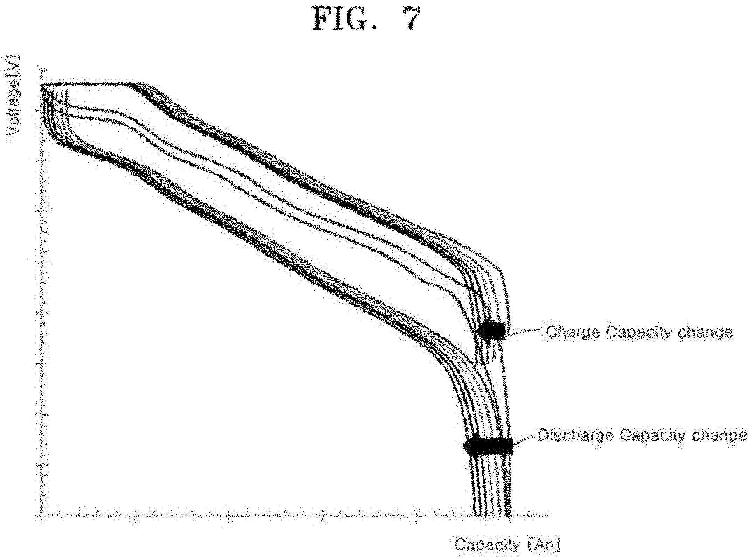

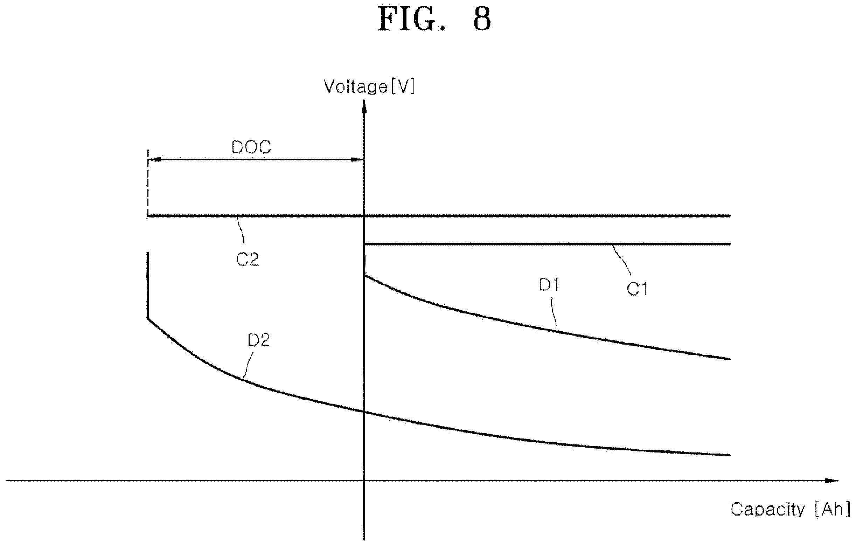

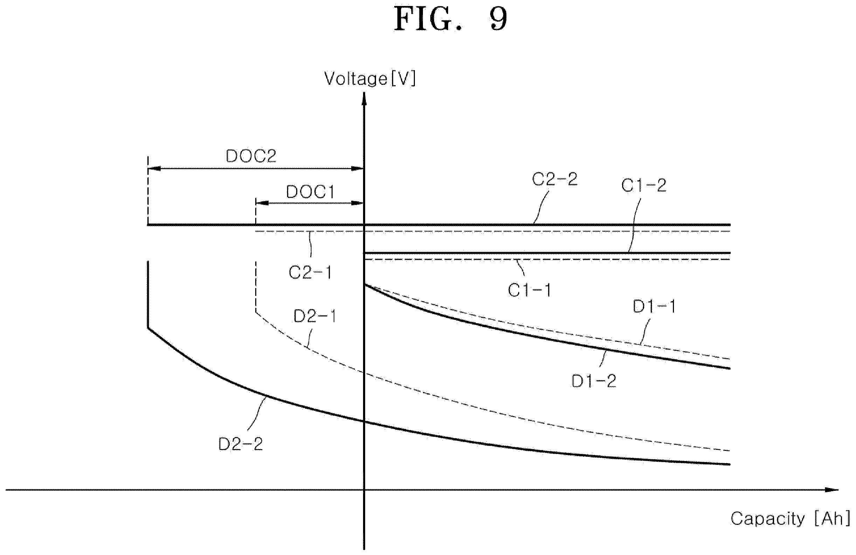

FIG. 2 is a block diagram illustrating an apparatus for analyzing a battery characteristic according to embodiments of the present disclosure. FIGS. 3 to 6 are example graphs showing a process of generating integrated characteristic data according to embodiments of the present disclosure. FIG. 7 is an example graph of integrated characteristic data according to embodiments of the present disclosure. FIGS. 8 and 9 are example graphs for describing a method of analyzing a lithium precipitation characteristic according to embodiments of the present disclosure.

Referring to FIG. 2, the apparatus for analyzing a battery characteristic according to the present embodiment may include a memory 100 and a processor 200.

The memory 100 may store at least one instruction executed by the processor 200 to be described herein. The memory 100 may be implemented as a volatile storage medium and/or a non-volatile storage medium and may be implemented as, for example, a read-only memory (ROM), a random access memory (RAM), a flash memory, or an electrically erasable programmable read-only memory (EEPROM).

In the present embodiment, the memory 100 may store first individual characteristic data and second individual characteristic data respectively acquired in first and second charge/discharge cycles, each of which consists of a charge operation and a discharge operation of a battery. The battery may be a lithium ion secondary battery and may correspond to a battery cell or a battery module. To help understand the present embodiment, in the present embodiment, an example in which two charge/discharge cycles are performed on a battery will be described. However, two charge/discharge cycles only mean the minimum number of charge/discharge cycles in which the present embodiment can be implemented and does not mean that the present embodiment can be applied only to two charge/discharge cycles. It should be noted that the present embodiment can also be applied to two or more charge/discharge cycles.

A charge/discharge cycle may be a cycle consisting of one battery charge operation and one battery discharge operation. C-rates applied to a charge operation and a discharge operation constituting one cycle may be the same or different (in order to help understand embodiments, the present embodiment will be described herein assuming that the same C-rate is applied to a charge operation and a discharge operation constituting one cycle). The second charge/discharge cycle follows the first charge/discharge cycle.

A C-rate applied to the second charge/discharge cycle may have a greater value than a C-rate applied to the first charge/discharge cycle. For example, a charge operation of the first charge/discharge cycle may correspond to a low-speed charge operation, and a charge operation of the second charge/discharge cycle may correspond to a high-speed charge operation. This serves as a premise for analyzing a lithium precipitation characteristic during high-speed charging based on a difference between capacity at a charge end point during high-speed charging and capacity at a charge end point during low-speed charging. A detailed description thereof will be provided herein.

The first individual characteristic data may be acquired during a first charge/discharge cycle that has been performed on a battery in the past and may be stored in the memory 100 or may be acquired in real time during the first charge/discharge cycle that is currently being performed on a battery and may be stored in the memory 100.

In addition, the first individual characteristic data may include first charge characteristic data C1 and first discharge characteristic data D1 which have a capacity coordinate as a reference axis (for example, an X-axis). The first charge characteristic data C1 may correspond to data according to the capacity and voltage of a battery during the charge operation of the first charge/discharge cycle and may correspond to, for example, charge curve data in which an X-axis is a capacity coordinate axis and a Y-axis is a voltage coordinate axis. Similarly, the first discharge characteristic data D1 may correspond to data according to the capacity and voltage of a battery during the discharge operation of the first charge/discharge cycle and may correspond to discharge curve data in which an X-axis is a capacity coordinate axis and a Y-axis as a voltage coordinate axis.

The second individual characteristic data may be acquired during the first charge/discharge cycle that has been performed on a battery in the past and may be stored in the memory 100 or may be acquired in real time during the second charge/discharge cycle that is currently being performed on a battery and may be stored in the memory 100.

In addition, the second individual characteristic data may include second charge characteristic data C2 and second discharge characteristic data D2 which have a capacity coordinate as a reference axis (for example, an X-axis). The second charge characteristic data C2 may correspond to data according to the capacity and voltage of a battery during the charge operation of the second charge/discharge cycle and may correspond to, for example, charge curve data in which an X-axis is a capacity coordinate axis and a Y-axis is a voltage coordinate axis. Similarly, the second discharge characteristic data D2 may correspond to data according to the capacity and voltage of a battery during the discharge operation of the second charge/discharge cycle and may correspond to discharge curve data in which an X-axis is a capacity coordinate axis and a Y-axis as a voltage coordinate axis.

In the present embodiment, the first charge characteristic data C1 and the second charge characteristic data C2 may have a form in which capacity coordinates are inverted.

FIG. 3 shows an example of the first charge characteristic data C1 and the first discharge characteristic data D1 constituting the first individual characteristic data. A description will focus on the first charge characteristic data C1. As compared to FIG. 1, it can be confirmed that the first charge characteristic data C1 of FIG. 3 has a form in which capacity coordinates are inverted. A form in which capacity coordinates are inverted may be a form in which capacity coordinate values of data values (for example, coordinate data of (capacity, voltage)) constituting charge characteristic data are inverted with respect to each other based on a center data value. For example, during the charge operation of the first charge/discharge cycle, when data values (raw data values) (coordinate data of (capacity, voltage)) corresponding to a charge start point are (0 mAh, 2.5 V) and data values (raw data values) corresponding to a charge end point are (5,000 mAh, 4.2 V), in the first charge characteristic data C1, data values corresponding to a charge start point may be (5,000 mAh, 2.5 V), and data values corresponding to a charge end point may be (0 mAh, 4.2 V). A process of processing raw data into the first charge characteristic data C1 through inversion of capacity coordinates may be performed by the processor 200 to be described herein. The above configuration is equally applied to the second charge characteristic data C2, and a capacity coordinate inversion structure of the first charge characteristic data C1 and the second charge characteristic data C2 serves as a base structure for generating integrated characteristic data adopted to identify a time series characteristic change and a lithium precipitation characteristic of a battery cell in the present embodiment.

Next, the processor 200 may generate integrated characteristic data from the first individual characteristic data and the second individual characteristic data described herein to analyze the charge or discharge characteristics of a battery. In an example in which the first individual characteristic data and the second individual characteristic data are acquired through the first and second charge/discharge cycles that have been performed in the past and are prestored in the memory 100, the processor 200 may be implemented as an application specific integrated Circuit (ASIC), a digital signal processor (DSP), a programmable logic device (PLD), a field programmable gate array (FPGA), a central processing unit (CPU), a microcontroller, and/or a microprocessor and may be configured to drive an operating system or an application and control a plurality of hardware or software components to perform an operation of generating integrated characteristic data to be described herein and an operation of analyzing charge and discharge characteristics of a battery. In an example in which the first individual characteristic data and the second individual characteristic data are acquired through the first and second charge/discharge cycles which are currently performed and stored in the memory 100, the processor 200 may be implemented as a microcontroller unit (MCU) or an analog front end integrated circuit (IC) (AFE IC) of a battery management system (BMS) that controls the charge operation and the discharge operation of the first and second charge/discharge cycles and may be configured to drive an operating system or an application and control a plurality of hardware or software components to perform an operation of generating integrated characteristic data described herein and an operation of analyzing charge and discharge characteristics of a battery.

In the present embodiment, the processor 200 aligns the first discharge characteristic data D1 constituting the first individual characteristic data with the second charge characteristic data C2 constituting the second individual characteristic data to generate integrated characteristic data in which the first individual characteristic data and the second individual characteristic data are integrated and may analyze a charge characteristic or discharge characteristic of a battery based on the generated integrated characteristic data.

First, a process of generating integrated characteristic data will be described.

The processor 200 may align the first discharge characteristic data D1 with the second charge characteristic data C2 based on reference capacity coordinate values defined according to the first discharge characteristic data D1. Here, the reference capacity coordinate values may be capacity coordinate values corresponding to a discharge end point of the first discharge characteristic data D1.

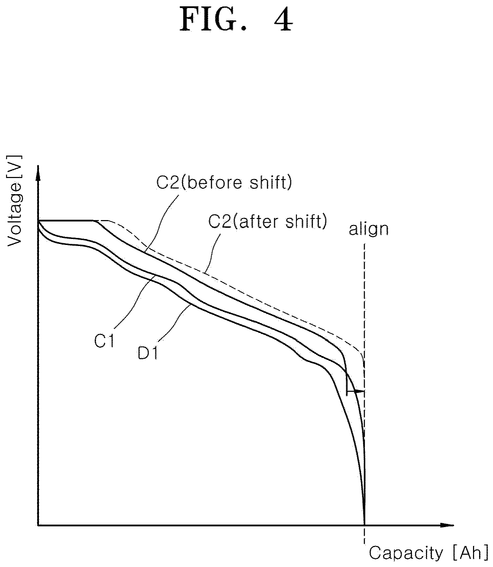

FIG. 3 shows an example of the first charge characteristic data C1 and the first discharge characteristic data D1 of the first individual characteristic data, and FIG. 4 shows an example of the first individual characteristic data and the second charge characteristic data C2 of the second individual characteristic data. In a state in which the first individual characteristic data is provided as shown in FIG. 3, the processor 200 may shift the second charge characteristic data C2 such that a charge start point of the second charge characteristic data C2 of FIG. 4 has the same capacity coordinate values as a discharge end point of the first discharge characteristic data D1. In FIG. 4, the second charge characteristic data C2 indicated by a solid line corresponds to data before the shift, and the second charge characteristic data C2 indicated by a dotted line corresponds to data after the shift.

In this case, the processor 200 shifts the second charge characteristic data C2 by a difference between charge capacity of the second charge characteristic data C2 and discharge capacity of the first discharge characteristic data D1 (hereinafter referred to as "capacity difference"), thereby aligning the first discharge characteristic data D1 with the second charge characteristic data C2 based on reference capacity coordinate values. That is, in the example of FIG. 4, since capacity coordinate values of a charge start point of the second charge characteristic data C2 correspond to the charge capacity of the second charge characteristic data C2, and capacity coordinate values of a discharge end point of the first discharge characteristic data D1 correspond to the discharge capacity of the first discharge characteristic data D1, the processor 200 may shift the second charge characteristic data C2 by the capacity difference between the charge capacity of the second charge characteristic data C2 and the discharge capacity of the first discharge characteristic data D1, thereby matching the capacity coordinate values of the charge start point of the second charge characteristic data C2 with the capacity coordinate values of the discharge end point of the first discharge characteristic data D1.

For example, when charge capacity of the first charge characteristic data C1 is 5,000 mAh, discharge capacity of the first discharge characteristic data D1 is 4,900 mAh, charge capacity of the second charge characteristic data C2 is 4,700 mAh, and discharge capacity of the second discharge characteristic data D2 is 4,600 mAh, the processor 200 may shift the entire first charge characteristic data C1 by 200 mAh which is a difference between the charge capacity (4,700 mAh) of the second charge characteristic data C2 and the discharge capacity (4,900 mAh) of the first discharge characteristic data D1.

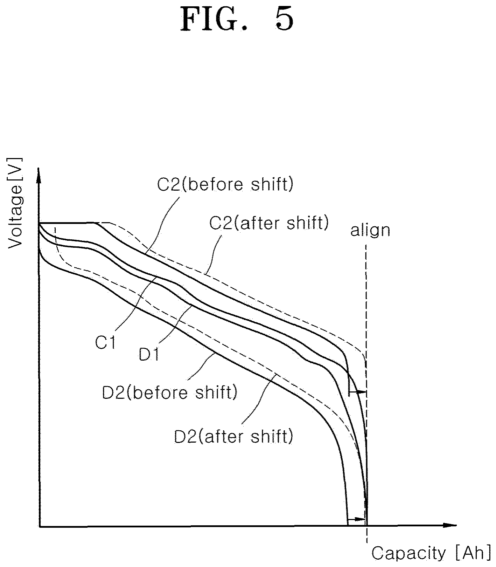

While performing an operation of shifting the first charge characteristic data C1, the processor 200 may shift the second discharge characteristic data D2 by a capacity difference to align the second charge characteristic data C2 with the second discharge characteristic data D2 based on capacity coordinate values corresponding to a charge end point of the second charge characteristic data C2. That is, as shown in FIG. 5, the processor 200 may also shift the second discharge characteristic data D2 by a capacity difference (200 mAh in the above example), and thus a charge end point of the second charge characteristic data C2 and a discharge start point of the second discharge characteristic data D2 may have the same capacity coordinate values. In FIG. 5, the second discharge characteristic data D2 indicated by a solid line corresponds to data before the shift, and the second discharge characteristic data D2 indicated by a dotted line corresponds to data after the shift.

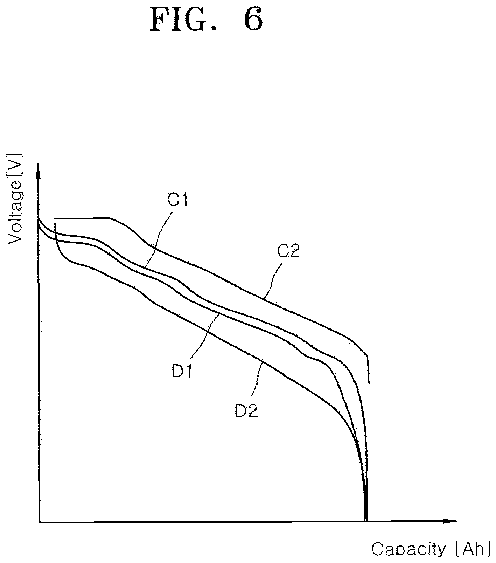

FIG. 6 shows an example of integrated characteristic data generated by shifting the second charge characteristic data C2 and the second discharge characteristic data D2 by a capacity difference. As can be confirmed from FIG. 6, the first discharge characteristic data D1, the first charge characteristic data C1, and the second discharge characteristic data D2 have continuous capacity coordinate values (this does not mean that a curve of each characteristic data is continuous without disconnection, but means that capacity coordinates of the first discharge characteristic data D1, capacity coordinates of the first charge characteristic data C1, and capacity coordinates of the second discharge characteristic data D2 have continuous values).

FIG. 7 shows an example of integrated characteristic data generated from seven pieces of individual characteristic data acquired when seven charge/discharge cycles are performed. Data shown at the upper part of FIG. 7 corresponds to charge characteristic data, and data shown at the lower part of FIG. 7 corresponds to discharge characteristic data. Capacity coordinate values corresponding to a charge start point (see the right end in FIG. 7) of the charge characteristic data refer to charge capacity, and capacity coordinate values corresponding to a discharge end point (see the right end in FIG. 7) of the discharge characteristic data refer to discharge capacity. It can be confirmed that the charge characteristic data and the discharge characteristic data show a tendency to shift entirely to the left as a charge/discharge cycle is performed, which means that charge capacity and discharge capacity are degraded as the charge/discharge cycle is being performed. The integrated characteristic data shown as an example in FIG. 7 may be rendered as graphic data and provided to a user through a user interface (for example, a PC (personal computer) or tablet PC) so that the user may visually and easily identify a time series characteristic change of a battery cell that occurs while a plurality of charge/discharge cycles are performed.

In addition, based on the integrated characteristic data, the processor 200 may be configured to analyze the degradation of charge capacity using a charge characteristic of a battery or analyze the degradation of discharge capacity of a battery using a discharge characteristic of the battery. For example, in the example of FIG. 7, the processor 200 may calculate a difference between charge capacity of the first charge characteristic data C1 and charge capacity of seventh charge characteristic data and may determine that the degradation of the charge capacity of the battery is increased as the calculated difference is increased. Similarly, the processor 200 may calculate a difference between discharge capacity of the first discharge characteristic data D1 and discharge capacity of the seventh discharge characteristic data and may determine that the degradation of the discharge capacity of the battery is increased as the calculated difference is increased.

Meanwhile, the processor 200 may be configured to analyze a lithium precipitation characteristic of a battery during charging based on the integrated characteristic data.

As described herein, in the case of high-speed charging of a battery (for example, a lithium ion battery), there is a large amount of lithium precipitation as compared to low-speed charging, which is related to a capacity value at a charge end point. That is, in the case of high-speed charging, as capacity at a charge end point is increased, a lithium precipitation amount is increased (since the charge characteristic data has a form in which capacity coordinates are inverted in the present embodiment, in the present embodiment, it should be interpreted that a lithium precipitation amount is increased as capacity coordinates of the charge characteristic data at a charged end point are decreased).

Capacity at a charge end point during low-speed charging may be adopted as a criterion for determining a lithium precipitation amount formed during high-speed charging. Capacity at a charge end point may be defined as a depth of charge (DOC), and as a difference between a DOC during high-speed charging and a DOC during low-speed charging is increased, a lithium precipitation amount may be increased.

Accordingly, in the present embodiment, the processor 200 may analyze a lithium precipitation characteristic based on a difference between first capacity coordinate values corresponding to a charge end point of the first charge characteristic data C1 and second capacity coordinate values corresponding to a charge end point of the second charge characteristic data C2 in the integrated characteristic data. A lithium precipitation characteristic may include one or more of a lithium precipitation amount and a precipitation side reaction amount according to lithium precipitation. As described herein, the first charge characteristic data C1 may correspond to data acquired during a charge operation of the first charge/discharge cycle corresponding to low-speed charging, and the second charge characteristic data C2 may correspond to data acquired during a charge operation of the second charge/discharge cycle corresponding to low-speed charging.

A difference between the first capacity coordinate values and the second capacity coordinate values corresponds to a difference between capacity at a charge end point during low-speed charging and capacity at a charge end point during high-speed charging, and a large difference means a large difference between a DOC of low-speed charging and a DOC of high-speed charging. Accordingly, the processor 200 may determine that a lithium precipitation amount during high-speed charging of a battery is increased as the difference between the first capacity coordinate values and the second capacity coordinate values is increased.

FIG. 8 is an example enlarged graph showing a charge end point of an integrated characteristic graph. In the example of FIG. 8, capacity coordinate values of a charge end point of the first charge characteristic data C1 is set to a value of 0, and therefore, in this case, a lithium precipitation amount may be determined according to a DOC of the second charge characteristic data C2, that is, a magnitude (which may be an absolute value) of second capacity coordinate values corresponding to a charge end point of the second charge characteristic data C2. In the example of FIG. 8, it can be determined that a precipitation amount of a lithium is increased as a magnitude of a DOC of the second charge characteristic data C2 is increased (that is, as the charge end point of the second charge characteristic data C2 is shifted to the left).

FIG. 9 is an example enlarged graph showing charge end points in an integrated characteristic graph generated for first and second batteries. In FIG. 9, C1-1, D1-1, C2-1, and D2-1 indicate first charge characteristic data, first discharge characteristic data, second charge characteristic data, and second discharge characteristic data acquired for the first battery, respectively, and C1-2, D1-2, C2-2, and D2-2 indicate first charge characteristic data, first discharge characteristic data, second charge characteristic data, and second discharge characteristic data acquired for the second battery, respectively. In FIG. 9, capacity coordinate values of charge end points of the first charge characteristic data C1-1 and the first charge characteristic data C1-2 of the first and second batteries are set to a value of 0. A DOC DOC2 of the second charge characteristic data C2-2 of the second battery is shown to be greater than a DOC DOC1 of the second charge characteristic data C2-1 of the first battery. Accordingly, in the example of FIG. 9, it may be determined in the second battery that a lithium precipitation amount formed during high-speed charging is greater than that in the first battery.

The integrated characteristic data shown as an example in FIGS. 8 and 9 may be rendered as graphic data and provided to a user through a user interface (for example, a PC or tablet PC), and thus the user may visually and intuitively check a lithium precipitation amount formed during high-speed charging for a specific battery and may also visually and intuitively check a relationship among lithium precipitation amounts formed during high-speed charging for a plurality of batteries. In addition, based on the integrated characteristic data, even when an extremely small amount of lithium is precipitated, a lithium precipitation amount may be accurately detected.

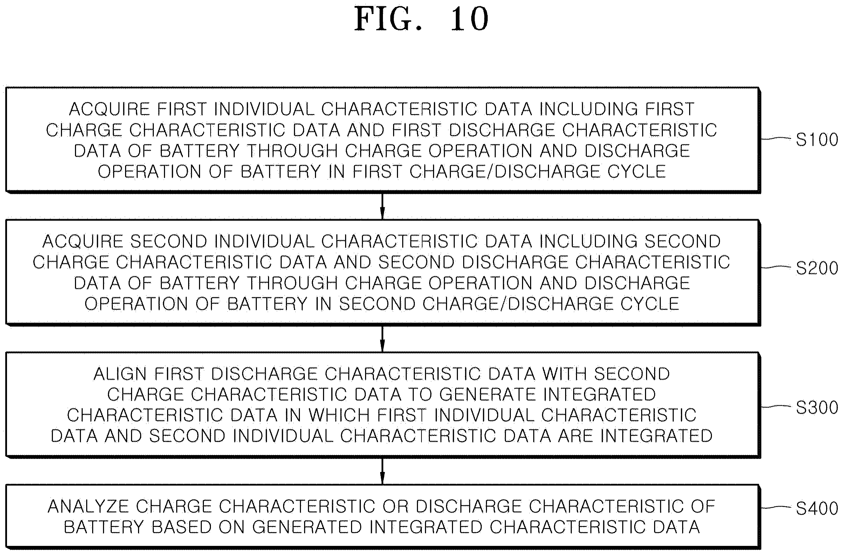

FIG. 10 is a flowchart illustrating a method of analyzing a battery characteristic according to embodiments of the present disclosure. The method of analyzing a battery characteristic according to embodiments of the present embodiment will be described with reference to FIG. 10. Detailed descriptions of contents that overlap the herein-described contents will be omitted, and the description will focus on a time series configuration.

First, a processor 200 obtains first individual characteristic data including first charge characteristic data C1 and first discharge characteristic data D1 of a battery through a charge operation and a discharge operation of the battery in a first charge/discharge cycle (S100). In this case, the processor 200 may acquire the first charge characteristic data C1 having a form in which capacity coordinates are inverted with respect to raw data through inversion of capacity coordinates of the raw data of capacity and voltage acquired when the charge operation is performed.

Next, the processor 200 acquires second individual characteristic data including second charge characteristic data C2 and second discharge characteristic data D2 of the battery through the charge operation and discharge operation of the battery in a second charge/discharge cycle (S200). As in operation S100, the processor 200 may acquire the second charge characteristic data C2 having a form in which capacity coordinates are inverted with respect to raw data through inversion of capacity coordinates of the raw data of capacity and voltage acquired when the charge operation is performed. A C-rate applied to the second charge/discharge cycle has a greater value than a C-rate applied to the first charge/discharge cycle.

When the first individual characteristic data and the second individual characteristic data are acquired in advance and already stored in a memory 100, operations S100 and S200 may be omitted.

Next, the processor 200 aligns the first discharge characteristic data D1 with the second charge characteristic data C2 to generate integrated characteristic data in which the first individual characteristic data and the second individual characteristic data are integrated (S300).

In operation S300, the processor 200 may align the first discharge characteristic data D1 with the second charge characteristic data C2 based on reference capacity coordinate values corresponding to a discharge end point of the first discharge characteristic data D1, and specifically, the second charge characteristic data C2 may be shifted by a capacity difference between charge capacity of the second charge characteristic data C2 and discharge capacity of the first discharge characteristic data D1, thereby aligning the first discharge characteristic data D1 with the second charge characteristic data C2 based on the reference capacity coordinate values.

In addition, in operation S300, the processor 200 may shift the second discharge characteristic data D2 by the capacity difference to align the second charge characteristic data C2 with the second discharge characteristic data D2 based on capacity coordinate values corresponding to a charge end point of the second charge characteristic data C2.

When integrated data is generated through operation S300, the processor 200 analyzes a charge characteristic or a discharge characteristic of the battery based on the integrated characteristic data (S400). In operation S400, the processor 200 analyzes the degradation of charge capacity using the charge characteristic of the battery or the degradation of discharge capacity of the battery using the discharge characteristic of the battery based on the integrated characteristic data.

In addition, in operation S400, the processor 200 analyzes a lithium precipitation characteristic of the battery while performing charging based on the integrated characteristic data. In this case, the processor 200 analyzes the lithium precipitation characteristic based on a difference between first capacity coordinate values corresponding to a charge end point of the first charge characteristic data C1 and second capacity coordinate values corresponding to the charge end point of the second charge characteristic data C2 in the integrated characteristic data and determines that a lithium precipitation amount is increased while charging the battery as the difference between the first capacity coordinate values and the second capacity coordinate values is increased.

As described herein, according to the present disclosure, a plurality of individual characteristic data acquired during a plurality of charge/discharge cycles of a battery are aligned with each other based on capacity coordinates to generate integrated characteristic data, and a charge characteristic or a discharge characteristic of the battery is analyzed based on the generated integrated characteristic data, thereby identifying a time series characteristic change of a battery cell that occurs during the plurality of charge/discharge cycles, and at the same time, accurately detecting lithium precipitation that may occur during high-speed charging of the battery.

However, effects that can be achieved through the present disclosure are not limited to the herein-described effects and other effects that are not described may be clearly understood by those skilled in the art from the detailed descriptions.

Implementations described herein may be implemented in, for example, a method or process, an apparatus, a software program, a data stream, or a signal. Although discussed only in the context of a single form of implementation (e.g., discussed only as a method), implementations of the discussed features may also be implemented in other forms (for example, an apparatus or a program). The apparatus may be implemented in suitable hardware, software, firmware, etc. A method may be implemented in an apparatus such as a processor, which is generally a computer, a microprocessor, an integrated circuit, a processing device including a programmable logic device, etc. Processors also include communication devices, such as a computer, a cell phone, a portable/personal digital assistant ("PDA"), and other devices that facilitate communication of information between end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the claims.

Embodiments are set out in the following numbered clauses:
1. An apparatus for analyzing a battery characteristic, the apparatus comprising:
   a memory configured to store first individual characteristic data and second individual characteristic data respectively acquired in a first charge/discharge cycle and a second charge/discharge cycle, each of which consists of a charge operation and a discharge operation of a battery, wherein the first individual characteristic data includes first charge characteristic data and first discharge characteristic data which have a capacity coordinate as a reference axis, and the second individual characteristic data includes second charge characteristic data and second discharge characteristic data which have a capacity coordinate as a reference axis; and
   a processor configured to align the first discharge characteristic data with the second charge characteristic data to generate integrated characteristic data in which the first individual characteristic data and the second individual characteristic data are integrated and analyze a charge characteristic or discharge characteristic of the battery based on the generated integrated characteristic data.
2. The apparatus of clause 1, wherein the first charge characteristic data and the second charge characteristic data have a form in which the capacity coordinate is inverted.
3. The apparatus of clause 1 or clause 2, wherein the processor aligns the first discharge characteristic data with the second charge characteristic data based on reference capacity coordinate values defined according to the first discharge characteristic data.
4. The apparatus of clause 3, wherein the reference capacity coordinate values are capacity coordinate values corresponding to a discharge end point of the first discharge characteristic data.
5. The apparatus of clause 4, wherein the processor aligns the first discharge characteristic data with the second charge characteristic data based on the reference capacity coordinate values by shifting the second charge characteristic data by a capacity difference between charge capacity of the second charge characteristic data and discharge capacity of the first discharge characteristic data.
6. The apparatus of clause 5, wherein the processor shifts the second discharge characteristic data by the capacity difference to align the second charge characteristic data with the second discharge characteristic data based on capacity coordinate values corresponding to a charge end point of the second charge characteristic data.
7. The apparatus of any preceding clause, wherein the processor analyzes a lithium precipitation characteristic while charging the battery based on the integrated characteristic data.
8. The apparatus of clause 7, wherein the processor analyzes the lithium precipitation characteristic based on a difference between first capacity coordinate values corresponding to a charge end point of the first charge characteristic data and second capacity coordinate values corresponding to a charge end point of the second charge characteristic data in the integrated characteristic data.
9. The apparatus of clause 8, wherein the processor determines that a lithium precipitation amount is increased while charging the battery as the difference between the first capacity coordinate values and the second capacity coordinate values is increased.
10. The apparatus of any preceding clause, wherein a C-rate applied to the second charge/discharge cycle has a greater value than a C-rate applied to the first charge/discharge cycle.
11. The apparatus of any preceding clause, wherein based on the integrated characteristic data, the processor analyzes degradation of charge capacity using the charge characteristic of the battery or analyzes degradation of discharge capacity of the battery using the discharge characteristic of the battery.
12. An apparatus for analyzing a battery characteristic, the apparatus comprising:
   a processor; and
   a memory configured to store instructions executed by the processor,
   wherein the processor is configured to:
      acquire first individual characteristic data including first charge characteristic data and first discharge characteristic data of a battery through a charge operation and a discharge operation of the battery in a first charge/discharge cycle;
      acquire second individual characteristic data including second charge characteristic data and second discharge characteristic data of the battery through a charge operation and a discharge operation of the battery in a second charge/discharge cycle;
      align the first discharge characteristic data with the second charge characteristic data to generate integrated characteristic data in which the first individual characteristic data and the second individual characteristic data are integrated; and
      analyze a charge characteristic or a discharge characteristic of the battery based on the generated integrated characteristic data.
13. A method of analyzing a battery characteristic, the method comprising:
   acquiring, by a processor, first individual characteristic data including first charge characteristic data and first discharge characteristic data of a battery through a charge operation and a discharge operation of the battery in a first charge/discharge cycle;
   acquiring, by the processor, second individual characteristic data including second charge characteristic data and second discharge characteristic data of the battery through a charge operation and a discharge operation of the battery in a second charge/discharge cycle;
   aligning, by the processor, the first discharge characteristic data with the second charge characteristic data and generating integrated characteristic data in which the first individual characteristic data and the second individual characteristic data are integrated; and
   analyzing, by the processor, a charge characteristic or a discharge characteristic of the battery based on the generated integrated characteristic data.
14. The method of clause 13, wherein, in the generating of the integrated characteristic data, the processor aligns the first discharge characteristic data with the second charge characteristic data based on reference capacity coordinate values defined according to the first discharge characteristic data.
15. The method of clause 14, wherein the reference capacity coordinate values are capacity coordinate values corresponding to a discharge end point of the first discharge characteristic data.
16. The method of clause 15, wherein, in the generating of the integrated characteristic data, the processor aligns the first discharge characteristic data with the second charge characteristic data based on the reference capacity coordinate values by shifting the second charge characteristic data by a capacity difference between charge capacity of the second charge characteristic data and discharge capacity of the first discharge characteristic data.
17. The method of clause 16, wherein, in the generating of the integrated characteristic data, the processor shifts the second discharge characteristic data by the capacity difference to align the second charge characteristic data with the second discharge characteristic data based on capacity coordinate values corresponding to a charge end point of the second charge characteristic data.
18. The method of any of clauses 13 to 17, wherein, in the analyzing of the charge characteristic or the discharge characteristic, the processor analyzes a lithium precipitation characteristic while charging the battery using the charge characteristic of the battery based on the integrated characteristic data.
19. The method of clause 18, wherein, in the analyzing of the charge characteristic or the discharge characteristic, the processor analyzes the lithium precipitation characteristic based on a difference between first capacity coordinate values corresponding to a charge end point of the first charge characteristic data and second capacity coordinate values corresponding to a charge end point of the second charge characteristic data in the integrated characteristic data.
20. The method of clause 19, wherein, in the analyzing of the charge characteristic or the discharge characteristic, the processor determines that a lithium precipitation amount is increased while charging the battery as the difference between the first capacity coordinate values and the second capacity coordinate values is increased.

## Claims

1. An apparatus for analyzing a battery characteristic, the apparatus comprising:
a memory configured to store first individual characteristic data and second individual characteristic data respectively acquired in a first charge/discharge cycle and a second charge/discharge cycle, each of which consists of a charge operation and a discharge operation of a battery, wherein the first individual characteristic data includes first charge characteristic data and first discharge characteristic data which have a capacity coordinate as a reference axis, and the second individual characteristic data includes second charge characteristic data and second discharge characteristic data which have a capacity coordinate as a reference axis; and
a processor configured to align the first discharge characteristic data with the second charge characteristic data to generate integrated characteristic data in which the first individual characteristic data and the second individual characteristic data are integrated and analyze at least one of a charge characteristic and a discharge characteristic of the battery based on the generated integrated characteristic data.

2. The apparatus of claim 1, wherein the first charge characteristic data and the second charge characteristic data have a format in which the capacity coordinate is inverted.

3. The apparatus of claim 1 or claim 2, wherein the processor is configured to align the first discharge characteristic data with the second charge characteristic data based on reference capacity coordinate values defined according to the first discharge characteristic data.

4. The apparatus of claim 3, wherein the reference capacity coordinate values are capacity coordinate values corresponding to a discharge end point of the first discharge characteristic data.

5. The apparatus of claim 4, wherein the processor is configured to align the first discharge characteristic data with the second charge characteristic data based on the reference capacity coordinate values by shifting the second charge characteristic data by a capacity difference between charge capacity of the second charge characteristic data and discharge capacity of the first discharge characteristic data.

6. The apparatus of claim 5, wherein the processor is configured to shift the second discharge characteristic data by the capacity difference to align the second charge characteristic data with the second discharge characteristic data based on capacity coordinate values corresponding to a charge end point of the second charge characteristic data.

7. The apparatus of any preceding claim, wherein the processor is configured to analyze a lithium precipitation characteristic while charging the battery based on the integrated characteristic data.

8. The apparatus of claim 7, wherein the processor is configured to analyze the lithium precipitation characteristic based on a difference between first capacity coordinate values corresponding to a charge end point of the first charge characteristic data and second capacity coordinate values corresponding to a charge end point of the second charge characteristic data in the integrated characteristic data.

9. The apparatus of claim 8, wherein the processor is configured to determine that a lithium precipitation amount is increased while charging the battery as the difference between the first capacity coordinate values and the second capacity coordinate values is increased.

10. The apparatus of any preceding claim, wherein a C-rate applied to the second charge/discharge cycle has a greater value than a C-rate applied to the first charge/discharge cycle.

11. The apparatus of any preceding claim, wherein the processor is configured, based on the integrated characteristic data, to analyze degradation of charge capacity using the charge characteristic of the battery and/or to analyze degradation of discharge capacity of the battery using the discharge characteristic of the battery.

12. An apparatus for analyzing a battery characteristic, the apparatus comprising:
a processor; and
a memory configured to store instructions executed by the processor,
wherein the processor is configured to:
acquire first individual characteristic data including first charge characteristic data and first discharge characteristic data of a battery through a charge operation and a discharge operation of the battery in a first charge/discharge cycle;
acquire second individual characteristic data including second charge characteristic data and second discharge characteristic data of the battery through a charge operation and a discharge operation of the battery in a second charge/discharge cycle;
align the first discharge characteristic data with the second charge characteristic data to generate integrated characteristic data in which the first individual characteristic data and the second individual characteristic data are integrated; and
analyze a charge characteristic or a discharge characteristic of the battery based on the generated integrated characteristic data.

13. A method of analyzing a battery characteristic, the method comprising:
acquiring, by a processor, first individual characteristic data including first charge characteristic data and first discharge characteristic data of a battery through a charge operation and a discharge operation of the battery in a first charge/discharge cycle;
acquiring, by the processor, second individual characteristic data including second charge characteristic data and second discharge characteristic data of the battery through a charge operation and a discharge operation of the battery in a second charge/discharge cycle;
aligning, by the processor, the first discharge characteristic data with the second charge characteristic data and generating integrated characteristic data in which the first individual characteristic data and the second individual characteristic data are integrated; and
analyzing, by the processor, a charge characteristic or a discharge characteristic of the battery based on the generated integrated characteristic data.

14. The method of claim 13, wherein, in the generating of the integrated characteristic data, the processor aligns the first discharge characteristic data with the second charge characteristic data based on reference capacity coordinate values defined according to the first discharge characteristic data, the reference capacity coordinate values being capacity coordinate values corresponding to a discharge end point of the first discharge characteristic data,
wherein, in the generating of the integrated characteristic data, the processor aligns the first discharge characteristic data with the second charge characteristic data based on the reference capacity coordinate values by shifting the second charge characteristic data by a capacity difference between charge capacity of the second charge characteristic data and discharge capacity of the first discharge characteristic data, and
wherein, in the generating of the integrated characteristic data, the processor shifts the second discharge characteristic data by the capacity difference to align the second charge characteristic data with the second discharge characteristic data based on capacity coordinate values corresponding to a charge end point of the second charge characteristic data.

15. The method of claim 13 or claim 14, wherein, in the analyzing of the charge characteristic or the discharge characteristic, the processor analyzes a lithium precipitation characteristic while charging the battery using the charge characteristic of the battery based on the integrated characteristic data,
wherein, in the analyzing of the charge characteristic or the discharge characteristic, the processor analyzes the lithium precipitation characteristic based on a difference between first capacity coordinate values corresponding to a charge end point of the first charge characteristic data and second capacity coordinate values corresponding to a charge end point of the second charge characteristic data in the integrated characteristic data, and
wherein, in the analyzing of the charge characteristic or the discharge characteristic, the processor determines that a lithium precipitation amount is increased while charging the battery as the difference between the first capacity coordinate values and the second capacity coordinate values is increased.
